# EUROPEAN PATENT APPLICATION

(11) **EP 4 462 956 A1**
(43) Date of publication of application: **13.11.2024**
(21) Application number: 23172258.8
(22) Date of filing: 09.05.2023
(51) Int. Cl.: H05K 1/02, H05K 1/11, H05K 1/14, H05K 3/36, B64C 1/00, H01R 12/52, H01R 12/71, H01R 13/24

(54) **SELF-GUIDING ELECTRIC CONNECTOR**

(71) Applicant: Airbus Operations GmbH, 21129 Hamburg (DE)
(72) Inventor: Brückmann, Konstantin, 21129 Hamburg (DE); Hahn, Dennis, 21129 Hamburg (DE); Kurz, Kilian, 21129 Hamburg (DE); Blum, Noel, 21129 Hamburg (DE); Thurn, Carlos, 21129 Hamburg (DE)
(74) Representative: Schornack, Oliver

(57) **Abstract**

The present disclosure relates to a connector for enabling an electrical connection between principal surfaces of two planar panels by being sandwiched between the two planar panels. The connector comprises a deformable main body having a first elongated cuboid shape and having, perpendicular to the longitudinal direction of the first elongated cuboid shape, a first rectangular cross-section, and a conductive layer fully enclosing the circumference of the first rectangular cross-section along a portion of the longitudinal direction of the deformable main body.

## Description

### Technical Field

The present disclosure generally relates to a self-guiding electric connector. In particular, the present disclosure relates to a self-guiding electric connector in the fields of cabin/cargo electronics, printed electronics and data transfer, e.g. in civil/military aviation. The self-guiding electric connector of the present disclosure pertains particularly to printed electrics and a corresponding modular architecture.

In addition, the connector may also be used to connect flexible printed circuits (FPCs).

### Background

Currently, there already are different connectors employing a variety of connection principles. However, the shape of such connectors in general and attachment of the connector to the foil in particular do not yet meet the requirements pertaining to printed electrics.

With the currently available connections, a separate connector (e.g. male/female) needs to be incorporated requiring a free floating strip of cable, or more specifically, a free floating tail of substrate with conductive tracks. The problem with the free floating tail of the substrate is, as it needs to have a certain length in order to connect the panel to the power and data bus, that it cannot be properly stowed (bent/folded) when it is mounted, which in turn provides further stress to the substrate.

Document DE 10 2018 127 044 A1 may be construed to disclose a panelling part for a cabin of a means of transportation, which includes at least one display unit and at least one control unit, which are produced by printing and equipping at least one film, which is applied to a panelling element. The control unit can communicate wirelessly with an external electronics unit, so that the panelling part only requires a power terminal to implement electronic functions. Functions can be retrofitted easily by replacing the at least one film.

### Summary

Accordingly, there is a need for an implementation of a scheme that avoids one or more of the problems discussed above, or other related problems.

These objects are solved by the present invention as defined by the independent claim. Preferred embodiments are defined by the dependent claims.

Without loss of generality, the present disclosure can be summarized as follows. The connector enables an electrical connection between two rigid flat printed tracks embedded in a panel. Therefore, an additional flexible layer will be placed between the two tracks and said layer is equipped with electrical conductors through the layer itself. When the two panels are pressed together, e.g. by two magnets, the flexible layer will be pressed on both sides against the electrical tracks to ensure a stable connection. Additionally, through the magnetic pressure, the humidity and moisture seal is tightened.

In addition, the present disclosure enables the following advantages:
- A universal connector concept for a wide range of use is attained.
- Adjustment of the connector to panel thickness is possible.
- A so-called "hands-off" feature is provided that enables an easy connection of a functionalized panel to a power and data bus without the need of an installation lid or a free floating cable/substrate tail. Accordingly, a split-line free design is possible.
- In terms of installation and maintenance/repair of the panel or behind it, the connector of the present disclosure will not incur any costs in terms of time spent at all.

According to a first aspect of the present disclosure, there is provided a connector for enabling an electrical connection between principal surfaces of two planar panels by being sandwiched between the two planar panels. The connector comprises a deformable main body having a first elongated cuboid shape and having, perpendicular to the longitudinal direction of the first elongated cuboid shape, a first rectangular cross-section, and a conductive layer fully enclosing the circumference of the first rectangular cross-section along a portion of the longitudinal direction of the deformable main body.

According to a first refinement of the first aspect, the conductive layer preferably is one of a number of conductive layers, each of which fully enclose the circumference of the first rectangular cross-section along separate portions along the longitudinal direction. In this regard, the separate portions preferably are equally spaced apart from one another in the longitudinal direction. Moreover, the number is preferably 4. In addition, each conductive layer is preferably comprised of a conductive pad.

According to a second refinement of the first aspect, the connector preferably further comprises a first deformable side body having a second elongated cuboid shape and having, perpendicular to the longitudinal direction of the second elongated cuboid shape, a second rectangular cross-section, and a second deformable side body having a third elongated cuboid shape and having, perpendicular to the longitudinal direction of the third elongated cuboid shape, a third rectangular cross-section. In that case, the first and second deformable side bodies preferably are spaced part from the deformable main body. Still further, the conductive layer preferably does not enclose the circumference of the second and third rectangular cross-sections. Moreover, the longitudinal direction of the deformable main body and the longitudinal directions of the first and second deformable side bodies preferably are parallel to one another, and the first and second deformable side bodies preferably are arranged at opposing sides of the deformably main body. In addition, the second and third cuboid shapes preferably are identical to one another, the second and third rectangular cross-sections preferably are identical to one another, the first, second and third cuboid shapes preferably have equal lengths along the longitudinal directions and preferably have equal thickness perpendicular to the longitudinal directions, the second and third cuboid shapes preferably have equal widths perpendicular to the longitudinal directions, and the first cuboid shape preferably has a width perpendicular to the longitudinal directions greater than the widths of the second and third cuboid shapes.

According to a third refinement of the first aspect, the connector preferably further comprises a first end portion at a first end of the deformable main body in the longitudinal direction, and a second end portion at a second end of the deformable main body opposing the first end in the longitudinal direction. In that case, the first end portion preferably connects the first end of the deformable main body to respective first ends of the first and second deformable side bodies in the longitudinal direction, and the second end portion preferably connects the second end of the deformable main body to respective second ends of the first and second deformable side bodies opposed to the first ends of the first and second deformable side bodies in the longitudinal direction. Still further, the first end portion preferably comprises a first connector bracket enabling the connector to be fastened to at least one of two planar panels, and the second end portion preferably comprises a second connector bracket enabling the connector to be fastened to at least one of two planar panels. Moreover, the deformable main body, the first and second deformable side bodies as well as the first and second end portions preferably are one integral body.

Pertaining to the first aspect as well as to the first to third refinements, the deformable main body and/or the first and second deformable side bodies preferably are comprised of pressure-sensitive layers.

### Brief Description of the Drawings

The embodiments of the technique presented herein are described herein below with reference to the accompanying drawings, in which:
Fig. 1A shows a top view of the apparatus according to an embodiment of the present disclosure;
Fig. 1B shows a cut-out view of the apparatus according to the embodiment of the present disclosure;
Fig. 2 shows an overview of the apparatus according to a use case of the embodiment of the present disclosure; and
Fig. 3 shows a model manufactured according to the embodiment of the present disclosure.

### Detailed Description

In the following description, for purposes of explanation and not limitation, specific details are set forth in order to provide a thorough understanding of the technique presented herein. It will be apparent to one skilled in the art that the present technique may be practiced in other embodiments that depart from these specific details.

Moreover, those skilled in the art will appreciate that the services, functions and steps explained herein may be implemented using software functioning in conjunction with a programmed microprocessor, or using an Application Specific Integrated Circuit (ASIC), a Digital Signal Processor (DSP) or general purpose computer. It will also be appreciated that while the following embodiments are described in the context of methods and devices, the technique presented herein may also be embodied in a computer program product as well as in a system comprising a computer processor and a memory coupled to the processor, wherein the memory is encoded with one or more programs that execute the services, functions and steps disclosed herein. This applies especially to the aspect of an automated injection moulding process for manufacturing the connector of the present disclosure.

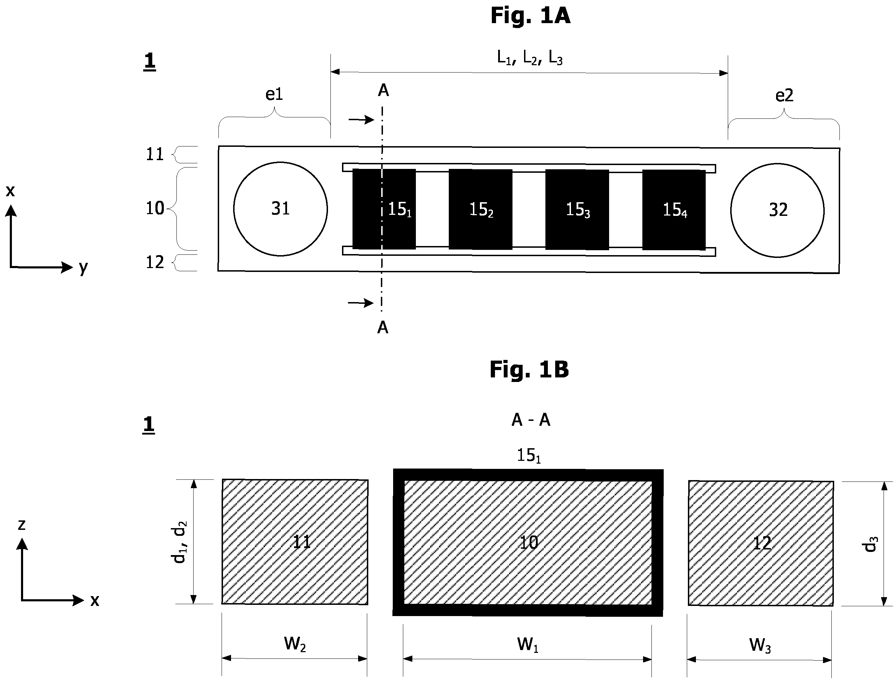

Fig. 1A shows a top view of the apparatus (connector 1) according to an embodiment of the present disclosure, while Fig. 1B shows a cut-out view along the line A-A in Fig. 1A of the apparatus (connector 1) according to the embodiment of the present disclosure.

According to the present disclosure, there is provided a connector 1 for enabling an electrical connection between principal surfaces of two planar panels P1, P2 by being sandwiched between the two planar panels P1, P2. The connector 1 comprises a deformable main body 10 having a first elongated cuboid shape and having, perpendicular to the longitudinal direction y of the first elongated cuboid shape, a first rectangular cross-section (see Fig. 1B), and a conductive layer 15, 15₁, 15₂, 15₃, 15₄ fully enclosing the circumference of the first rectangular cross-section along a portion of the longitudinal direction of the deformable main body 10.

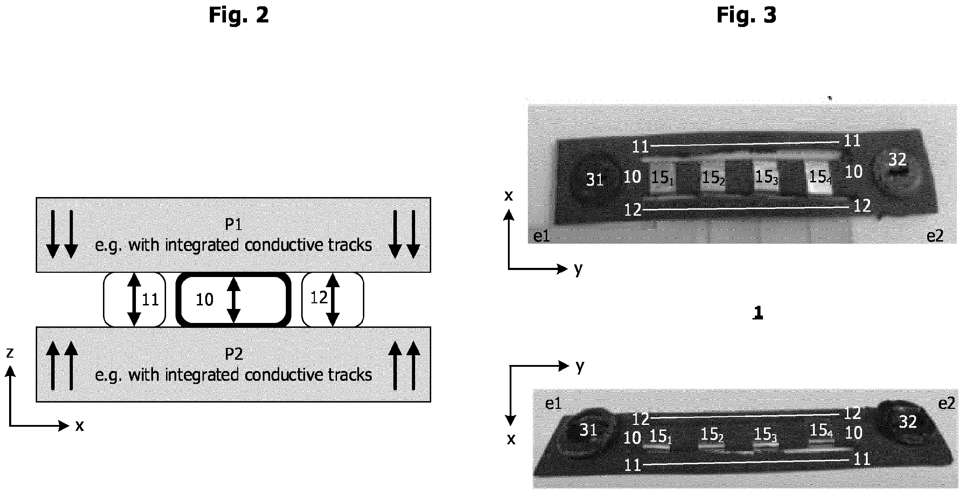

In this regard, the conductive layer 15 preferably is one of a number (e.g. 4) of conductive layers 15₁, 15₂, 15₃, 15₄, each of which fully enclose the circumference of the first rectangular cross-section along separate portions along the longitudinal direction y (see Fig. 1A). Moreover, the separate portions preferably are equally spaced apart from one another in the longitudinal direction, and each conductive layer is preferably comprised of a conductive pad. By distributing the conductive layer in this fashion, it is ascertained that sufficient conduction between the panels P1, P2 is attained (see also Fig. 2).

Still further, Fig. 2 shows an overview of the apparatus (connector 1) according to a use case of the embodiment of the present disclosure.

In this regard, the connector preferably further comprises a first deformable side body (11) having a second elongated cuboid shape and having, perpendicular to the longitudinal direction y of the second elongated cuboid shape, a second rectangular cross-section, and a second deformable side body 12 having a third elongated cuboid shape and having, perpendicular to the longitudinal direction y of the third elongated cuboid shape, a third rectangular cross-section (see Fig. 1B). In this regard, the first and second deformable side bodies 11, 12 preferably are spaced apart from the deformable main body 10. In that case, the conductive layer 15 preferably does not enclose the circumference of the second and third rectangular cross-sections. Moreover, the longitudinal direction of the deformable main body 10 and the longitudinal directions of the first and second deformable side bodies 11, 12 preferably are parallel to one another, and the first and second deformable side bodies 11, 12 preferably are arranged at opposing sides of the deformably main body 10 (see Figs. 1A and 1B). Finally, the second and third cuboid shapes preferably are identical to one another, the second and third rectangular cross-sections preferably are identical to one another, the first, second and third cuboid shapes preferably have equal lengths L₁, L₂, L₃ along the longitudinal directions y and preferably have equal thickness d₁, d₂, d₃ perpendicular to the longitudinal directions y, the second and third cuboid shapes preferably have equal widths W₂, W₃ perpendicular to the longitudinal directions y, and the first cuboid shape preferably has a width W₁ perpendicular to the longitudinal directions y greater than the widths W₂, W₃ of the second and third cuboid shapes.

That is, as is best seen in Fig. 2, the panels P1, P2 can be clipped together and locked to each other, so that the connector 1 between these two panels will be squeezed together.

In this regard, according to the present disclosure, the deformable main body 10 as well as the first and second deformable side bodies 11, 12 are preferably comprised of pressure-sensitive layers (i.e., layers reacting on an applied pressure). In that case, the reinforcement properties of the pressure-sensitive material will push the conductive layer (e.g. conductive pad) 15 against the conductive track on the one hand and close the gap between the panels P1, P2 on the other hand. The attainable effect resides in that the conductive pad 15 (enclosing the deformable main body 10) will close the circuit to both sides in the middle, while the edges of the pressure sensitive pad (i.e., the first and second deformable side bodies 11, 12) will seal the connection area against humidity and moisture.

In an example, the force (double arrows in Fig. 2) that is necessary to squeeze the sandwich (consisting of panels P1, P2 and the connector 1) together is preferably realized by one of three different principles: 1. magnets in both sides of the panels P1, P2, 2. welding tape and 3. mechanical lock system.

Fig. 3 shows a model manufactured according to the embodiment of the present disclosure. The upper half of Fig. 3 shows a frontside of the connector 1 when installed, while the lower half of Fig. 3 shows a backside of the connector 1.

In this regard, according to the present disclosure, the connector 1 preferably further comprises a first end portion e1 at a first end of the deformable main body 10 in the longitudinal direction y, and a second end portion e2 at a second end of the deformable main body 10 opposing the first end in the longitudinal direction y. Still further, the first end portion e1 preferably connects the first end of the deformable main body 10 to respective first ends of the first and second deformable side bodies 11, 12 in the longitudinal direction y, and the second end portion e2 preferably connects the second end of the deformable main body 10 to respective second ends of the first and second deformable side bodies 11, 12 opposed to the first ends of the first and second deformable side bodies 11, 12 in the longitudinal direction y.

In addition, the first end portion e1 preferably comprises a first connector bracket 31 enabling the connector 1 to be fastened to at least one of two planar panels P1, P2, and the second end portion e2 preferably comprises a second connector bracket 32 enabling the connector 1 to be fastened to at least one of two planar panels P1, P2. In this way, overall structural stability of the connector 1 sandwiched between the planar panels P1, P2 is further improved.

Moreover, as is shown in Figs. 1A and 3, the deformable main body 10, the first and second deformable side bodies 11, 12 as well as the first and second end portions e1, e2 preferably are one integral body. This may lead to a simple manufacturing process for the connector 1 of the present disclosure:
(i) injection-moulding the connector 1 with a correspondingly adapted die, leaving two elongated cut-outs so as to form the deformable main body 10 as well as the first and second deformable side bodies 11, 12,
   or
   by providing single monolithic deformable body and cutting out/punching/boring two slits from said monolithic deformable body so as to form the deformable main body 10 as well as the first and second deformable side bodies 11, 12, and
(ii) wrapping one or more pieces of conductive foil around the circumference of the resulting main body 10.

Finally, the general term panel may pertain to usage of a flexible foil, but also encompasses a flexible printed circuit, FPC.

It is believed that the advantages of the technique presented herein will be fully understood from the foregoing description, and it will be apparent that various changes may be made in the form, constructions and arrangement of the exemplary aspects thereof without departing from the scope of the present disclosure or without sacrificing all of its advantageous effects. Because the technique presented herein can be varied in many ways, it will be recognized that the present disclosure should be limited only by the scope of the claims that follow.

## Claims

1. A connector (1) for enabling an electrical connection between principal surfaces of two planar panels (P1, P2) by being sandwiched between the two planar panels, the connector (1) comprising:
a deformable main body (10) having a first elongated cuboid shape and having, perpendicular to the longitudinal direction (y) of the first elongated cuboid shape, a first rectangular cross-section; and
a conductive layer (15, 15₁, 15₂, 15₃, 15₄) fully enclosing the circumference of the first rectangular cross-section along a portion of the longitudinal direction of the deformable main body.

2. The connector of claim 1, wherein:
the conductive layer is one of a number of conductive layers, each of which fully enclose the circumference of the first rectangular cross-section along separate portions along the longitudinal direction.

3. The connector of claim 2, wherein:
the separate portions are equally spaced apart from one another in the longitudinal direction.

4. The connector of claim 2 or 3, wherein:
the number of conductive layers is four.

5. The connector of any one of claims 2 to 4, wherein:
each conductive layer is comprised of a conductive pad.

6. The connector of any one of claims 1 to 5, further comprising:
a first deformable side body (11) having a second elongated cuboid shape and having, perpendicular to the longitudinal direction (y) of the second elongated cuboid shape, a second rectangular cross-section; and
a second deformable side body (12) having a third elongated cuboid shape and having, perpendicular to the longitudinal direction (y) of the third elongated cuboid shape, a third rectangular cross-section.

7. The connector of claim 6, wherein:
the first and second deformable side bodies are spaced part from the deformable main body.

8. The connector of claim 7, wherein:
the conductive layer does not enclose the circumference of the second and third rectangular cross-sections.

9. The connector of any of claims 6 to 8, wherein:
the longitudinal direction of the deformable main body and the longitudinal directions of the first and second deformable side bodies are parallel to one another; and
the first and second deformable side bodies are arranged at opposing sides of the deformable main body.

10. The connector of claim 9, wherein:
the second and third cuboid shapes are identical to one another,
the second and third rectangular cross-sections are identical to one another,
the first, second and third cuboid shapes have equal lengths (L₁, L₂, L₃) along the longitudinal directions and have equal thickness (d₁, d₂, d₃) perpendicular to the longitudinal directions;
the second and third cuboid shapes have equal widths (W₂, W₃) perpendicular to the longitudinal directions; and
the first cuboid shape has a width (W₁) perpendicular to the longitudinal directions greater than the widths of the second and third cuboid shapes.

11. The connector of any one of the preceding claims, further comprising:
a first end portion (e1) at a first end of the deformable main body in the longitudinal direction; and
a second end portion (e2) at a second end of the deformable main body opposing the first end in the longitudinal direction.

12. The connector of claims 6 and 11, wherein:
the first end portion connects the first end of the deformable main body to respective first ends of the first and second deformable side bodies in the longitudinal direction; and
the second end portion connects the second end of the deformable main body to respective second ends of the first and second deformable side bodies opposed to the first ends of the first and second deformable side bodies in the longitudinal direction.

13. The connector of claim 12, wherein:
the first end portion comprises a first connector bracket (31) enabling the connector to be fastened to at least one of two planar panels; and
the second end portion comprises a second connector bracket (32) enabling the connector to be fastened to at least one of two planar panels.

14. The connector of claim 12 or 13, wherein:
the deformable main body, the first and second deformable side bodies as well as the first and second end portions are one integral body.

15. The connector of any one of claims 6 to 14, wherein:
the deformable main body as well as the first and second deformable side bodies are comprised of pressure-sensitive layers.
